# EUROPEAN PATENT SPECIFICATION

(11) **EP 2 506 321 B1**
(45) Date of publication and mention of the grant of the patent: **23.01.2019**
(21) Application number: 11160026.8
(22) Date of filing: 28.03.2011
(51) Int. Cl.: H01L 33/50, H01L 33/20, B82Y 20/00, H01L 33/08, H01L 33/44, H01L 33/04, H01L 33/32

(54) **Light-emitting diode chip**
Leuchtdiodenchip
Puce à diode électroluminescente

(43) Date of publication of application: 03.10.2012
(73) Proprietor: Osram Opto Semiconductors Gmbh, 93055 Regensburg (DE)
(72) Inventor: Ristic, Jelena, Dr., 93047 Regensburg (DE); Straßburg, Martin, Dr., 93093 Donaustauf (DE); Lefebvre, Pierre, Dr., 34070 Montpellier (FR)
(74) Representative: Epping - Hermann - Fischer

(56) References cited:
- EP-A1- 2 242 120
- WO-A1-2007/007954
- WO-A1-2010/022064
- WO-A2-2010/065860
- US-A1- 2006 145 169
- US-A1- 2007 158 661
- US-A1- 2008 142 823
- US-A1- 2008 315 178
- US-B1- 7 745 315

## Description

A light-emitting diode chip is specified.

The document "On the mechanisms of spontaneous growth of III-nitride nanocolumns by plasma-assisted molecular beam epitaxy", Journal of Crystal Growth 310, 2008, pp 4035-4045, discloses a method for the production of III-nitride nanocolumns.

The document "N-face GaN nanorods: Continuous-flux MOVPE growth and morphological Properties", Journal of Crystal Growth, 315, 2011, pp 164-167, discloses a method for the production of N-face GaN nanorods.

The document "Continuous-flux MOVPE growth of position-controlled N-face GaN nanorods and embedded InGaN quantum wells", Nanotechnology 21 (2010) 305201 (5 pp), discloses a method for the production of N-face GaN nanorods.

The documents EP 2242120, WO 2007/007954, WO 2010/065860 and US 2008/0142823 describe semiconductor components with nanostructures. US 2006/145169 A1 discloses a semiconductor LED having an electrically inactive quantum dot wavelength conversion layer on the top surface of the semiconductor body, whose uppermost layer is a p-AlGaN layer having an aluminum content of 15% or less.

It is one object to specify a light-emitting diode chip having a good thermal stability.

The invention concerns the light-emitting diode chip according to claim 1.

According to at least one aspect of the light-emitting diode chip, the light-emitting diode chip comprises a semiconductor body having a top surface and at least one active region which emits electro-magnetic radiation during operation of the light-emitting diode chip. For example, the semiconductor body is the semiconductor body of a light-emitting diode. The semiconductor is, for example, epitaxially grown on a growth substrate which can be removed from the semiconductor body. During operation, the semiconductor body produces electro-magnetic radiation in the at least one active region. The electro-magnetic radiation is, for example, UV-radiation or visible light.

At least a part of the electro-magnetic radiation produced in the at least one active region leaves the semiconductor through its top surface. For example, the top surface is the surface of the semiconductor body facing away from a connection carrier or a circuit board on which the semiconductor body is mounted.

According to at least one aspect of the light-emitting diode chip, the semiconductor body is based on a III-V semiconductor compound material or a II-VI compound semiconductor material. In particular, the active region of the semiconductor body can be formed with this semiconductor compound material.

A III-V compound semiconductor material comprises at least one element from the third main group, such as, for example, B, Al, Ga, In, and an element from the fifth main group, such as, for example, N, P, As. In particular, the term "III/V compound semiconductor material" encompasses the group of the binary, ternary or quaternary compounds which contain at least one element from the third main group and at least one element from the fifth main group, for example, nitride and phosphide compound semiconductors. Such a binary, ternary or quaternary compound can additionally comprise, for example, one or more dopants and additional constituents.

Accordingly, a II-VI compound semiconductor material comprises at least one element from the second main group, such as for example Be, Mg, Ca, Sr, Zn, Cd, Hg and one element from the sixth main group, such as for example O, S, Se, Te. In particular, a II-VI compound semiconductor material comprises a binary, ternary or quaternary compound, which comprises at least one element from the second main group and at least one element from the sixth main group. Such a binary, ternary or quaternary compound may moreover comprise for example one or more dopants and additional constituents. The II-VI compound semiconductor materials for example include: ZnO, ZnMgO, CdS, ZnCdS, MgBeO.

According to at least one aspect of the light-emitting diode chip, the light-emitting diode chip comprises a converter element. The converter element is attached to the top surface of the semiconductor body. For example, it is possible that the converter element and the semiconductor body are in direct contact with each other and the interface between the converter element and the semiconductor body is the top surface of the semiconductor body. The converter element covers a large fraction of the top surface. For example, the converter element covers at least 50%, in particular at least 75% of the top surface of the semiconductor body. Accordingly, a large amount of the electro-magnetic radiation leaving the semiconductor body through the top surface impinges on the converter element.

According to at least one aspect of the light-emitting diode chip, the converter element absorbs at least a part of the radiation which leaves the semiconductor body through the top surface and re-emits electro-magnetic radiation having a larger wavelength than the absorbed electro-magnetic radiation. In other words, the converter element down-converts light emitted by the semiconductor body. The light emitted by the light-emitting diode chip comprising the semiconductor body and the converter element can therefore be mixed light which comprises fractions of converted and not converted light. Consequently, the light-emitting diode chip can emit multi-color light or white light.

According to at least one aspect of the light-emitting diode chip, the converter element comprises a plurality of nanostructures. A nanostructure is a nanoscale object having a diameter on its base which ranges from 1 to 1000 nm, for example 25 to 500 nm, in particular from 75 to 300 nm, preferably from 100 nm to 175 nm. The base of the nanostructure is the side of the nanostructure facing the top surface of the semiconductor body. "Diameter" does not necessarily imply that the base of the nanostructures is a of round shape. "Diameter" for example also denotes the maximum extension of a nanostructure at its base.

The nanostructures have an aspect ratio (length divided by diameter) of at least two. For example, the nanostructures can be directly produced on the top surface of the semiconductor body. Further, it is possible that the nanostructures are produced independently from the semiconductor body and transferred to the top surface of the semiconductor body. The converter element comprising the nanostructures is then, for example, bonded or glued to the top surface of the semiconductor body.

The nanostructure is a nanorod, a nanocolumn or a nanopyramid.

According to at least one aspect of the light-emitting diode chip, each nanostructure is based on a III-V or a II-VI compound semiconductor material. For example the nanostructures are formed with at least one of the following materials: InGaN, GaN, ZnO, ZnMgO, CdS, ZnCdS, MgBeO. According to at least one aspect of the light-emitting diode chip, the nanostructures are electrically inactive. That is to say the nanostructures are not pumped electrically in order for them to produce light but they are optically pumped with radiation emitted by the semiconductor body through its top surface. The light-emitting diode chip is free of electrical contacts which would contact the nanostructures. According to at least one aspect of the light-emitting diode chip, the light-emitting diode chip comprises a semiconductor body having a top surface and a converter element attached to the top surface, wherein the semiconductor body is based on a III-V or a II-VI compound semiconductor material. The semiconductor body comprises at least one active region which emits electro-magnetic radiation during operation of the light-emitting diode chip. At least a part of the electro-magnetic radiation leaves the semiconductor body through its top surface. The converter element absorbs at least a part of the radiation which leaves the semiconductor body through the top surface and re-emits electro-magnetic radiation having a larger wavelength than the absorbed electro-magnetic radiation. The converter element comprises a plurality of electrically inactive nanostructures and each nanostructure is based on III-V or a II-VI compound semiconductor material. According to at least one aspect of the light-emitting diode chip, the semiconductor body is based on a nitride compound semiconductor material. In particular, the active region of the semiconductor body can be formed with this semiconductor compound material. A semiconductor body based on a nitride compound semiconductor material is in particular suited for the emission of UV-radiation and/or visible light in the blue and/or green spectral range.

In the present context, "based on a nitride compound semiconductor material" means that the semiconductor layer sequence or at least one part thereof, particularly preferably the active zone, comprises or consists of a nitride compound semiconductor material, for example GaN, AlₙGa₁₋ₙN, InₙGa₁₋ₙN or else AlₙGaₘIn₁₋ₙ₋ₘN, where 0 ≤ n ≤ 1, 0 ≤ m ≤ 1 and n+m ≤ 1. In this case, this material need not necessarily have a mathematically exact composition according to the above formula. Rather, it can comprise, for example, one or more dopants and additional constituents. For the sake of simplicity, however, the above formula only comprises the essential constituents of the crystal lattice (Al, Ga, In, N), even if these can be replaced and/or supplemented in part by small amounts of further substances. However, a nitride compound semiconductor material always comprises nitrogen or a nitrogen compound.

According to at least one aspect of the light-emitting diode chip, each nanostructure is based on a nitride compound semiconductor material comprising indium. Such an indium comprising nitride compound semiconductor material is a material that has a good thermal stability at the desired wavelength re-emitted by this material. However, high indium concentrations are difficult to achieve in conventional thin film structures, especially in thicker films (for example, having a thickness greater than 20 nm) as they are desired for the conversion of light. However, it has been found that the indium content in nanostructures can be very high without introducing crystal defects in the light-emitting structure, i.e. the semiconductor body.

According to at least one aspect of the light-emitting diode chip, the light-emitting diode chip comprises a semiconductor body having a top surface and a converter element attached to the top surface, wherein the semiconductor body is based on a nitride compound semiconductor material. The semiconductor body comprises at least one active region which emits electro-magnetic radiation during operation of the light-emitting diode chip. At least a part of the electro-magnetic radiation leaves the semiconductor body through its top surface. The converter element absorbs at least a part of the radiation which leaves the semiconductor body through the top surface and re-emits electro-magnetic radiation having a larger wavelength than the absorbed electro-magnetic radiation. The converter element comprises a plurality of electrically inactive nanostructures and each nanostructure is based on a nitride compound semiconductor material which comprises indium.

The described light-emitting diode chip inter alia has the advantage that the temperature stability of the light-emitting diode chip is not determined by the converter element since the converter element can be made of the same or similar material as the semiconductor body. This provides significantly higher temperature stability in comparison, for example, to light-emitting diode chips having ceramic converter elements.

Further, it is possible to employ the nanostructures with high density and small distances between each other. This leads to a high conversion efficiency and a reduction of optical losses. The reduction of optical losses is due to the improved extraction efficiency of light passing through the converter element. The improved extraction efficiency can be due to the irregular, stochastic distribution of the nanostructures on the top surface of the semiconductor body. Further the increased extraction efficiency can be due to an improved light in-coupling into the nanostructures because of an enhanced matching of the reflective index or even larger reflective index of the nanostructures than the electrically driven semiconductor body below the nanostructure converter. Further the increased extraction efficiency can be given by different angles with which light impinges on the rim of the nanostructures and their large surface/volume ratio.

For example the mean distance between to nanostructures is between one and three times the diameter of the nanostructures. The small diameters of the nanostructures allow the plastic relaxation of strain by surface deformation without creating extended defects within the nanostructures. Hence, the lattice mismatch of high indium content in the nanostructures to the semiconductor body having a lower indium content does not impair the crystalline quality of the converter element.

Due to the electrically inactive nature, the nanostructures act as converter material only. Consequently, there is no need for an otherwise complicated electrical connection of the nanostructures. At the same time, electrical contacting of the light-emitting diode chip remains the same as in conventional light-emitting diode chips.

According to at least one aspect of the light-emitting diode, each nanostructure of the converter element is based on InGaN semiconductor material and the maximum indium content in at least one of the nanostructures is at least 2%, in particular at least 5% and/or the mean indium content in at least one of the nanostructures is at least 2%, in particular at least 5%. For example, the maximum indium content and/or the mean indium content are at least 20%. Nanostructures with such a high indium content are in particular suited for the conversion of UV-radiation and/or blue light produced in the active region of the semiconductor body.

According to at least one aspect of the light-emitting diode, each nanostructure of the converter element is based on InGaN semiconductor material and the indium content in at least one of the nanostructures varies along a direction of main extension, i.e. the height, of said nanostructure. In particular, it is possible that the indium content in each of the nanostructures varies along a direction of main extension of said nanostructure. The advantage of using nanostructures where the indium content varies intrinsically along the nanostructure is that the light emitted by the light-emitting diode chip has a broad white light spectrum of converted light. In other words, the white light is not composed e.g. by light having a peak in the blue range and a peak in the yellow range but similar to sunlight it has a continuous spectrum comprising wavelength from the spectral region of red light to the spectral region of blue light. It is further possible that the indium content in at least one of the nanostructures varies along a lateral direction which is perpendicular to the direction of main extension.

According to at least one aspect of the light-emitting diode, each nanostructure is based on InGaN semiconductor material and the maximum indium content and/or the mean indium content of at least 2 nanostructures of the converter element differ from each other by at least 5%. In other words, there are nanostructures in the converter element having largely different indium contents. Due to this difference in indium content for different nanostructures, the re-emission of in particular spectral broad light by the converter element is possible.

According to at least one aspect of the light-emitting diode chip, each nanostructure comprises at least one pn-junction and/or at least one quantum well structure and/or at least one multi-quantum well structure and/or at least one double heterostructure. By employing such structures, the wavelength of the light re-emitted by each nanostructure can be set particularly accurate. For example, the pn-junction allows for a tailoring of the position, where the light conversion takes place. Usually one would rather avoid using p-type material in the nanostructures since it contributes to significant absorption of light. However, using (multi-)quantum well structures or double heterostructures for better control of light conversion does not necessarily need a pn-junction.

As an alternative, it is possible that the nanostructures of the converter element do not comprise pn-junctions or quantum well structures, but the re-emission of light is due to the intrinsic band gap of the semiconductor material forming the nanostructures. In this case, the nanostructures can be produced particularly easy.

According to at least one aspect of the light-emitting diode, at least one of the nanostructures, in particular each of the nanostructures, has a maximum diameter of 100 nm and an aspect ratio of at least 3, for example of at least 5. Such nanostructures can be formed particularly dense on the top surface of the semiconductor body and have good conversion efficiency.

According to at least one aspect of the light-emitting diode chip, the converter element and the semiconductor body are monolithically integrated with each other. "Monolithically integrated" means that there is no additional bonding material between the converter element, for example the nanostructures, and the top surface of the semiconductor body. But converter element and semiconductor body are in direct contact with each other without a further element for adherence between them. For example, the nanostructures can be epitaxially grown on the top surface or synthesized by a sol-gel method or another form of low temperature (below 500 °C, in particular below 300 °C) chemical synthesis directly on the top surface of the semiconductor body.

According to at least one aspect of the light-emitting diode, the nanostructures are epitaxially grown on the top surface of the semiconductor body. For example, the nanostructures are grown by means of MOVPE (metalorganic vapor phase epitaxy) growth. Further, it is possible to grow the nanostructures by MBE (molecular beam epitaxy) growth.

The growth of the nanostructures can be performed in a self-organized way. Further is possible to use a mask layer for the growth of the nanostructures. For example a mask layer consisting of SINₓ is formed on the top surface of the semiconductor body. In this case, seeds for each nanostructure can be formed in openings of the mask layer directly on the top surface. The nanostructures then grow in the region of each seed. The use of a mask layer enables the formation of nanostructures at preselectable positions. This allows for an accurate setting of the density of the nanostructures. For example, the density of the nanostructures can be efficiently controlled by the thickness of the mask layer which is controlled via the deposition time of the mask layer and/or the extension of the openings of the mask layer. The use of a mask layer allows for the production of regular ordered nanostructures.

According to at least one aspect of the light-emitting diode, the nanostructures are grown by means of MBE growth and the semiconductor body is grown by means of MOVPE growth. In particular, the nanostructures are then grown by self-organized MBE growth. This yields structures with high aspect ratios and small diameters with, for example, a mean diameter for all nanostructures less or equal 70 nm, for example less or equal 50 nm. Consequently, a high density of the nanostructures can be reached by employing MBE growth of nanostructures. Further, the MBE growth of nanostructures provides excellent control of the indium concentration and indium concentrations up to 100% are possible. Therefore, MBE growth of nanostructures can be employed when especially high indium concentrations are needed. Due to the self-organized growth of the nanostructures, the costs for the MBE growth of nanostructures can be kept moderate.

In the light-emitting diode according to the present invention, the semiconductor body comprises a buffer layer based on AlGaN, wherein the top surface of the semiconductor body is an outer surface of the buffer layer. The aluminum content in the buffer layer is at least 60%.

The nanostructures are epitaxially grown on the outer surface of the buffer layer in a self-organized way. It is believed that due to the differences in strain between the buffer layer comprising aluminum and semiconductor body, the nanostructures form in a self-organized way even under MOVPE growth of the nanostructures. In this case, the wafer comprising the semiconductor body with the buffer layer on its top is not transferred into another machine to deposit the converter element but the converter element with the nanostructures can be grown in a self-organized growth mode in the same epitaxial chamber such that the entire device can be prepared in a single growth run.

Further, the buffer layer blocks carrier diffusion into the nanostructures and improves the current spreading on, for example, the p-side of the semiconductor body.

According to another example of a light-emitting diode a thin metal layer is applied between the top surface of the semiconductor body and the converter element. In this case it is possible that the buffer layer is absent. However, the buffer layer can also be present and the thin metal layer is applied to the buffer layer.

The thin metal layer has for example a thickness of at least 1 nm and 10 nm at the most. The thin metal layer comprises or consists of at least one of the following metals: Au, Ga, In, B, Ni, transition metals similar to nickel. The thin layer is not necessarily a closed layer, but the metal can be in the form of dots or droplets which are arranged on the top surface of the semiconductor body. Those dots or droplets are believed to act as seeds for the formation of nanostructures by epitaxial growth of the nanostructures on the top surface. In the following, the here described light-emitting diode is explained in more detail with regard to one embodiment of the light-emitting diode.
- FIG. 1: shows a schematic sectional view of an embodiment of a here described light-emitting diode.
- FIG. 2: shows a schematic sectional view of an example of a here described light-emitting diode.

In the exemplary embodiments and the figures, similar or similarily acting constituent parts are provided with the same reference symbols. The elements illustrated in the figures and their size relationships among one another should not be regarded as true to scale. Rather, individual elements may be represented with an exaggerated size for the sake of better representability and/or for the sake of better understanding.

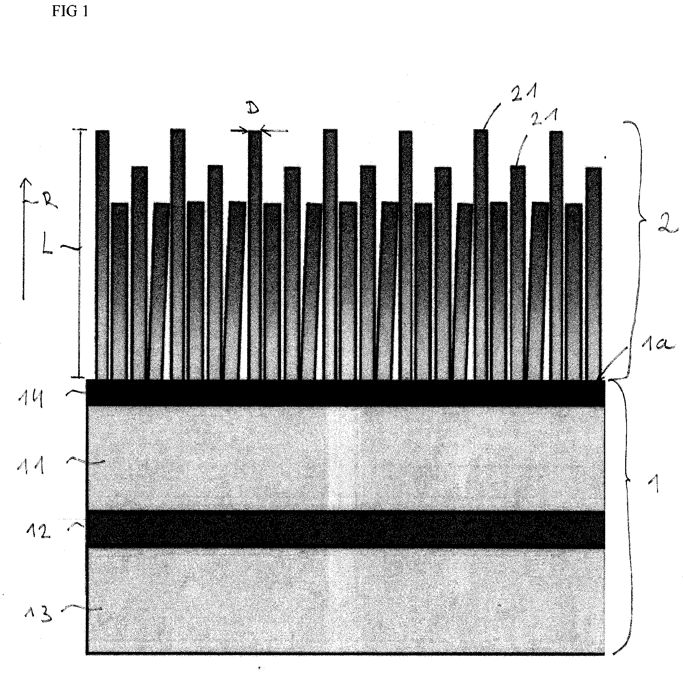

The light-emitting diode of figure 1 comprises a semiconductor body 1. The semiconductor body 1 is, for example, grown by MOVPE growth. The semiconductor 1 comprises an n-doped region 13, a p-doped region 11 and an active region 12. The regions 11, 12 and 13 are, for example, based on a nitride compound semiconductor material. During operation of the light-emitting diode chip, the active region emits electro-magnetic radiation in the spectral range between UV-radiation and visible light.

The semiconductor body 1 further comprises a buffer layer 14 which is applied to the side of p-doped region 11 facing away from active region 12. For example, the buffer layer 14 is formed with AlGaN semiconductor material during the epitaxial growth of the semiconductor body 1. Due to its aluminum content, the buffer layer 14 works as a carrier blocking layer 4 for carrier diffusion into converter element 2 which is applied on the side of the buffer layer 14 facing away from the active region 12. Further, the buffer layer 14 can improve the current spreading on the p-side of the semiconductor body 1.

The light-emitting diode chip further comprises a converter element 2 which is attached to the top surface 1a of the semiconductor body 1. The converter element absorbs at least a part of the radiation which leaves the semiconductor body 1 through the top surface 1a and re-emits electro-magnetic radiation having a larger wavelength than the absorbed electro-magnetic radiation. The converter element comprises a plurality of electrically inactive nanostructures 21. Each nanostructure has a diameter D and a length L.

For example, the mean diameter of all nanostructures 21 is 100 nm or lower. The length L of each nanostructure 21 is, for example, at least three times the diameter D.

The nanostructures are based on a nitride compound semiconductor material comprising indium. For example, each nanostructure has a mean indium content of at least 2%, in particular of at least 5%. Further, it is possible that the indium content in each nanostructure varies along a direction of main extension R, for example between 5% and 100%. Further, the maximum and/or the mean indium content of at least two nanostructures 21 of the converter element 2 may differ from each other by at least 5%.

During operation, such a light-emitting diode emits white light in a broad spectrum.

According to the embodiment of FIG. 1, the nanostructures 21 are formed in a self-organized way, for example by MOVPE growth. The buffer layer 14 formed with AlGaN has a high lattice mismatch with the nanostructure material and thus supports nucleation of nanostructure material. The thus produced nanostructures have a mean diameter below 100 nm and a very high density and high aspect ratio.

However, there are alternative ways for the formation of the converter element as explained above.

The light-emitting diode can be contacted in the usual way, for example with a top contact on top surface 1a and a bottom contact at the side of the n-doped region 13 facing away from the buffer layer 14. Further, it is possible that the contacts for the electrical connection of the light-emitting diode are formed on the same side of the semiconductor body.

Further, it is possible that layer 11 is an n-doped region and layer 13 is a p-doped region. In this case, the buffer layer 14 can be formed on a side of layer 11 from which a growth substrate for the epitaxial growth of the semiconductor 1 has been removed. For example the nanostructures are N-face nanostructures grown on the n-side of the semiconductor body 1 in this case. The nanostructures provide both, enhanced light extraction and light conversion. A additional roughening of the extraction surface 1a of the semiconductor body 1 can be omitted.

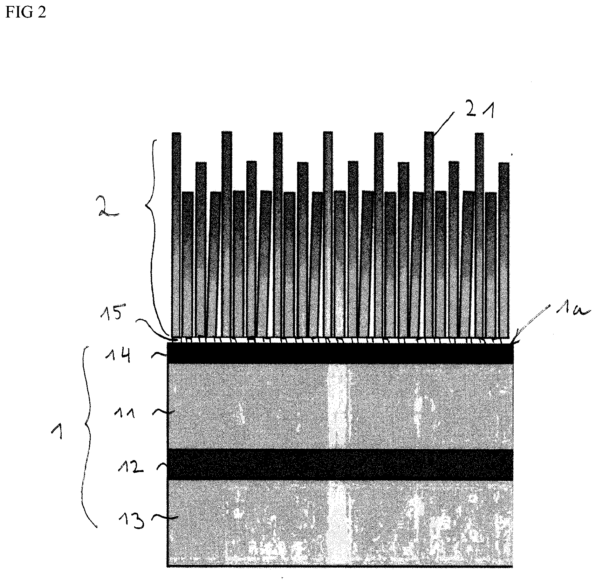

In addition to figure 1, figure 2 shows an example not forming part of the present invention, namely a light-emitting diode having a thin metal layer 15 which is applied between the top surface 1a of the semiconductor body 1 and the converter element 2. In this case it is possible that the buffer layer 14 is absent. However, as shown in figure 2 the buffer layer 14 can also be present and the thin metal layer 15 is applied to the buffer layer 14.

The thin metal layer 15 has for example a thickness of at least 1 nm and 10 nm at the most. The thin metal layer 15 comprises or consists of at least one of the following metals: Au, Ga, In, B, Ni, transition metals similar to nickel. In the present example the thin layer 15 is a non closed layer. The metal of the metal layer 15 is in the form of dots or droplets which are arranged on the top surface 1a of the semiconductor body 1. Those dots or droplets are believed to act as seeds for the formation of nanostructures 21 by epitaxial growth of the nanostructures 21 on the top surface 1a.

## Claims

1. A Light-emitting diode chip comprising:
- a semiconductor body (1) having a top surface (1a), and
- a converter element attached to the top surface (1a), wherein
- the semiconductor body (1) is based on a III-V or a II-VI semiconductor compound material,
- the semiconductor body (1) comprises at least one active region (12) which emits electro-magnetic radiation during operation of the light-emitting diode chip,
- at least a part of the electro-magnetic radiation leaves the semiconductor body (1) through the top surface (1a),
- the converter element (2) absorbs at least a part of the radiation which leaves the semiconductor body (1) through the top surface (1a) and re-emits electromagnetic radiation having a larger wavelength than the absorbed electromagnetic radiation,
- the converter element (2) comprises a plurality of electrically inactive nanostructures (21), and
- each nanostructure (21) is based on a III-V semiconductor compound material, wherein
- the semiconductor body (1) comprises a buffer layer based on AlGaN with an aluminum content of at least 60%,
- the buffer layer blocks carrier diffusion into the nanostructures,
- the top surface (1a) of the semiconductor body (1) is an outer surface of the buffer layer,
- the nanostructures (21) are epitaxially grown on the outer surface of the buffer layer in a self-organized way,
- the nanostructures (21) are nanorods, nanocolumns, or nanopyramids, and
- the nanostructures (21) are optically pumped with radiation emitted by the semiconductor body (1) through its top surface (1a).

2. The light-emitting diode chip according to the preceding claim, wherein
- the semiconductor body (1) is based on a nitride compound semiconductor material, and
- each nanostructure (21) is based on a nitride compound semiconductor material comprising indium.

3. The light-emitting diode chip according to the one of the preceding claims, wherein
- each nanostructure (21) is based on InGaN semiconductor material, and
- the maximum indium content in at least one of the nanostructures (21) is at least 2%.

4. The light-emitting diode chip according to the preceding claim, wherein
- each nanostructure (21) is based on InGaN semiconductor material, and
- the mean indium content in at least one of the nanostructures (21) is at least 2%.

5. The light-emitting diode chip according to one of the preceding claims, wherein
- each nanostructure (21) is based on InGaN semiconductor material, and
- the indium content in at least one of the nanostructures (21) varies along a direction of main extension of said nanostructure.

6. The light-emitting diode chip according to one of the preceding claims, wherein
- each nanostructure (21) is based on InGaN semiconductor material, and
- the maximum indium contents of at least two nanostructures (21) differ from each other by at least 5%.

7. The light-emitting diode chip according to one of the preceding claims, wherein
- each nanostructure (21) is based on InGaN semiconductor material, and
- the mean indium contents of at least two nanostructures (21) differ from each other by at least 5%.

8. The light-emitting diode chip according to one of the preceding claims, wherein
- the converter element (2) and the semiconductor body (1) are monolithically integrated with each other.

9. The light-emitting diode chip according to claim 1, wherein
- the nanostructures (21) are grown by means of MOVPE growth.

10. The light-emitting diode chip according to claim 9, wherein
- the nanostructures (21) are grown by means of MBE growth, and
- the semiconductor body (1) is grown by means of MOVPE growth.

## Patentansprüche

1. Ein lichtemittierender Diodenchip, umfassend:
- einen Halbleiterkörper (1) mit einer Oberfläche (1a) und
- ein an der Deckfläche (1a) befestigtes Konverterelement, wobei
- der Halbleiterkörper (1) auf einem III-V- oder einem II-VI-Halbleiterverbindungsmaterial basiert,
- der Halbleiterkörper (1) mindestens einen aktiven Bereich (12) umfasst, der während des Betriebs des lichtemittierenden Diodenchips elektromagnetische Strahlung emittiert,
- mindestens ein Teil der elektromagnetischen Strahlung den Halbleiterkörper (1) durch die Deckfläche (1a) verlässt,
- das Konverterelement (2) mindestens einen Teil der Strahlung absorbiert, die den Halbleiterkörper (1) durch die Deckfläche (1a) verlässt, und elektromagnetische Strahlung mit einer größeren Wellenlänge als die absorbierte elektromagnetische Strahlung wieder emittiert,
- das Konverterelement (2) eine Vielzahl von elektrisch inaktiven Nanostrukturen (21) umfasst, und
- jede Nanostruktur (21) auf einem III-V-Halbleiterverbindungsmaterial basiert, wobei
- der Halbleiterkörper (1) eine Pufferschicht auf Basis von AlGaN mit einem Aluminiumgehalt von mindestens 60% umfasst,
- die Pufferschicht die Ladungsträgerdiffusion in die Nanostrukturen blockiert,
- die Deckfläche (1a) des Halbleiterkörpers (1) eine Außenfläche der Pufferschicht ist,
- die Nanostrukturen (21) epitaktisch auf der Außenfläche der Pufferschicht in selbstorganisierter Weise gewachsen sind,
- die Nanostrukturen (21) Nanostäbchen, Nanosäulen oder Nanopyramiden sind und
- die Nanostrukturen (21) optisch mit Strahlung gepumpt werden, die vom Halbleiterkörper (1) durch seine Deckfläche (1a) abgegeben wird.

2. Lichtemittierender Diodenchip nach dem vorherigen Anspruch, wobei
- der Halbleiterkörper (1) auf einem Nitrid-Verbindungshalbleitermaterial basiert und
- jede Nanostruktur (21) auf einem Nitrid-Verbindungshalbleitermaterial basiert, das Indium umfasst.

3. Lichtemittierender Diodenchip nach einem der vorherigen Ansprüche, wobei
- jede Nanostruktur (21) auf InGaN-Halbleitermaterial basiert und
- der maximale Indium-Gehalt in mindestens einer der Nanostrukturen (21) mindestens 2% beträgt.

4. Lichtemittierender Diodenchip nach dem vorherigen Anspruch, wobei
- jede Nanostruktur (21) auf InGaN-Halbleitermaterial basiert und
- der mittlere Indium-Gehalt in mindestens einer der Nanostrukturen (21) mindestens 2% beträgt.

5. Lichtemittierender Diodenchip nach einem der vorherigen Ansprüche, wobei
- jede Nanostruktur (21) auf InGaN-Halbleitermaterial basiert und
- der Indium-Gehalt in mindestens einer der Nanostrukturen (21) entlang einer Richtung der Hauptausdehnung der Nanostruktur variiert.

6. Lichtemittierender Diodenchip nach einem der vorherigen Ansprüche, wobei
- jede Nanostruktur (21) auf InGaN-Halbleitermaterial basiert und
- sich der maximale Indium-Gehalt von mindestens zwei Nanostrukturen (21) um mindestens 5% voneinander unterscheidet.

7. Lichtemittierender Diodenchip nach einem der vorherigen Ansprüche, wobei
- jede Nanostruktur (21) auf InGaN-Halbleitermaterial basiert und
- der mittlere Indium-Gehalt von mindestens zwei Nanostrukturen (21) sich um mindestens 5% voneinander unterscheidet.

8. Lichtemittierender Diodenchip nach einem der vorherigen Ansprüche, wobei
- das Konverterelement (2) und der Halbleiterkörper (1) monolithisch miteinander integriert sind.

9. Lichtemittierender Diodenchip nach Anspruch 1, wobei
- die Nanostrukturen (21) mittels MOVPE-Wachstum gewachsen sind.

10. Lichtemittierender Diodenchip nach Anspruch 9, wobei
- die Nanostrukturen (21) durch MBE-Wachstum gewachsen sind, und
- der Halbleiterkörper (1) mittels MOVPE-Wachstum gewachsen ist.

## Revendications

1. Puce de diode électroluminescente comprenant:
- un corps semi-conducteur (1) présentant une face supérieure (la), et
- un élément convertisseur attaché à la face supérieure (la), dans laquelle
- le corps semi-conducteur (1) est à base d'un matériau composé semi-conducteur III-V ou II-VI,
- le corps semi-conducteur (1) comprend au moins une région active (12) qui émet un rayonnement électromagnétique lorsque la puce de diode électroluminescente est en marche,
- au moins une partie du rayonnement électromagnétique quitte le corps semi-conducteur (1) par la face supérieure (la),
- l'élément convertisseur (2) absorbe au moins une partie du rayonnement qui quitte le corps semi-conducteur (1) par la face supérieure (la), et renvoie le rayonnement électromagnétique ayant une longueur d'onde supérieure au rayonnement électromagnétique absorbé,
- l'élément convertisseur (2) comprend une pluralité de nanostructures électriquement inactives (21), et
- chaque nanostructure (21) est à base d'un matériau composé semi-conducteur III-V, dans laquelle
- le corps semi-conducteur (1) comprend une couche tampon à base d'AlGaN avec une teneur en aluminium d'au moins 60 %,
- la couche tampon bloque la diffusion de toute onde porteuse dans les nanostructures,
- la face supérieure (1a) du corps semi-conducteur (1) est une surface extérieure de la couche tampon,
- les nanostructures (21) sont formées par croissance épitaxiale sur la surface extérieure de la couche tampon d'une manière auto-organisée,
- les nanostructures (21) sont des nanobarres, des nano-colonnes ou des nanopyramides, et
- les nanostructures (21) sont pompées optiquement par le rayonnement émis par le corps semi-conducteur (1) par sa face supérieure (1a).

2. Puce de diode électroluminescente selon la revendication précédente, dans laquelle
- le corps semi-conducteur (1) est à base d'un matériau semi-conducteur composé de nitrure, et
- chaque nanostructure (21) est à base d'un matériau semi-conducteur composé de nitrure comprenant de l'indium.

3. Puce de diode électroluminescente selon l'une des revendications précédentes, dans laquelle
- chaque nanostructure (21) est à base de matériau semi-conducteur de type InGaN, dans laquelle
- la teneur maximale en indium dans au moins une des nanostructures (21) est d'au moins 2 %.

4. Puce de diode électroluminescente selon la revendication précédente, dans laquelle
- chaque nanostructure (21) est à base de matériau semi-conducteur de type InGaN, et
- la teneur moyenne en indium dans au moins une des nanostructures (21) est d'au moins 2 %.

5. Puce de diode électroluminescente selon l'une des revendications précédentes, dans laquelle
- chaque nanostructure (21) est à base de matériau semi-conducteur de type InGaN, et
- la teneur en indium dans au moins une des nanostructures (21) varie selon une direction d'extension principale de ladite nanostructure.

6. Puce de diode électroluminescente selon l'une des revendications précédentes, dans laquelle
- chaque nanostructure (21) est à base de matériau semi-conducteur de type InGaN, et
- les teneurs maximales en indium d'au moins deux nanostructures (21) diffèrent l'une de l'autre d'au moins 5 %.

7. Puce de diode électroluminescente selon l'une des revendications précédentes, dans laquelle
- chaque nanostructure (21) est à base de matériau semi-conducteur de type InGaN, et
- les teneurs moyennes en indium d'au moins deux nanostructures (21) diffèrent l'une de l'autre d'au moins 5 %.

8. Puce de diode électroluminescente selon l'une des revendications précédentes, dans laquelle
- l'élément convertisseur (2) et le corps semi-conducteur (1) sont intégrés l'un à l'autre de manière monolithique.

9. Puce de diode électroluminescente selon la revendication 1, dans laquelle
- les nanostructures (21) sont formées par croissance par MOVPE.

10. Puce de diode électroluminescente selon la revendication 9, dans laquelle
- les nanostructures (21) sont formées par croissance par MBE, et
- le corps semi-conducteur (1) est formé par croissance par MOVPE.
